Europäisches Patentamt

**European Patent Office**

Office européen des brevets

(11) Publication number: **0 066 404**
**B1**

(12) **EUROPEAN PATENT SPECIFICATION**

(45) Date of publication of patent specification: **30.12.86**

(21) Application number: **82302499.7**

(22) Date of filing: **17.05.82**

(51) Int. Cl.⁴: **H 01 J 37/317**

(54) **Multi-channel electron beam accessed lithography apparatus and method of operating the same.**

<table>
<tr><td>

(30) Priority: **21.05.81 US 266074**

(43) Date of publication of application:
**08.12.82 Bulletin 82/49**

(45) Publication of the grant of the patent:
**30.12.86 Bulletin 86/52**

(84) Designated Contracting States:
**DE FR GB**

(56) References cited:
**US-A-3 715 580**
**US-A-4 142 132**

</td><td>

(73) Proprietor: **CONTROL DATA CORPORATION**
**8100-34th Avenue South**
**Minneapolis Minnesota 55440 (US)**

(72) Inventor: **Smith, Donald Oscar**
**16 Dewey Road**
**Lexington Massachusetts 02173 (US)**
Inventor: **Harte, Kenneth Jeremy**
**64 Estabrook Road**
**Carlisle Massachusetts 01741 (US)**

(74) Representative: **Caro, William Egerton et al**
**J. MILLER & CO. Lincoln House 296-302 High**
**Holborn**
**London WC1V 7JH (GB)**

</td></tr>
</table>

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to multiple channel electron beam array lithography (EBAL) apparatus and methods of operating the same.

In US—A—4142132 there is disclosed a multi-channel electron beam array lithography apparatus comprising a plurality of parallel operated electron beam channels of the array optics type each of which is of the fly's eye type having an electron gun for producing an electron beam, an array lenslet assembly, a respective fine deflector assembly and a coarse deflector for selectively directing the electron beam to desired array lenslet within the array lenslet assembly and its respective fine deflector which thereafter directs the electron beam to a desired point on a target surface and an evactuated housing.

In one aspect the present invention provides a multi-channel electron beam array lithography apparatus which is of this type, which is characterised in that the evacuated housing encloses all of said electron beam channels and in that said apparatus further comprises a common movable stage for supporting the target surface below the electron beam channels and for moving the target surface relative to all the electron beam channels, and target position control means for automatically moving said common movable stage in a preprogrammed manner whereby substantially the entire surface area of the target surface can be brought under the combined view of the electron beam channels, the common movable stage being selectively movable in an x—y plane that is substantially normal to the electron beam channels by an automatically controlled x—y translation mechanism under the control of said target position control means, the translation mechanism being mechanically coupled to the movable stage.

According to another aspect of the present invention there is provided a method of operating a multi-channel electron beam array lithography apparatus as presented above and having a plurality of electron beam channels of the array optics type contained within a common evacuated housing, each of said channels comprising an electron gun for producing an electron beam, an array lenslet assembly, an array fine deflector assembly, and a coarse deflector assembly interposed between the electron gun and the array lenslet assembly for selectively directing the electron beam to a desired array lenslet of the array lenslet assembly and it respective fine deflector which directs the electron beam to a desired point on a target surface, said method comprising: operating all of said electron beam channels simultaneously in parallel in response to common pattern controlled deflection signals applied in common to the respective coarse and fine deflector assemblies of each electron beam channel thereby to write on different predetermined areas of the target surface simultaneously.

The invention is illustrated, merely by way of example, in the accompanying drawings, in which:—

Figure 1 is a schematic top plan view of a multi-channel EBAL apparatus according to the present invention;

Figure 2 is a combined schematic block diagram and schematic longitudinal sectional view of the multi-channel EBAL apparatus according to the present invention;

Figures 3A and 3B are a schematic circuit block diagram of an EBAL apparatus according to the present invention having a plurality of stations such as shown in Figures 1 and 2;

Figure 4 is a characteristic graph illustrating the relationship between certain operating parameters of an EBAL apparatus according to the present invention;

Figure 5 is a series of schematic sketches illustrating different hypothetical situations under conditions where the target surfaces viewed by individual electron beam channels of EBAL apparatus according to the present invention is smaller than but not commensurate with the field of view (A), the target surface exceeds the field of view of the individual electron beam channel in one dimension (B) and the target surface is smaller than the field of view of the individual electron beam channels in both dimensions (C); and

Figure 6 is a top plan view of an EBAL apparatus according to the present invention where the centre optical axes of the outer arranged electron beam channels can be mechanically moved relative to each other to accommodate different wafer diameters at 100% efficiency of wafer surface usage.

Throughout the drawings, like parts have been designated by the same reference numerals. As noted in the preceding description, the through-put (or productivity) of an EBAL apparatus can be increased by using multiple parallel electron beam channels of the array optics type to expose a plurality of target surfaces simultaneously. In the following description, the disclosure will be with relation to an enlarged semiconductor wafer on which it is desired to form a plurality of semiconductor integrated circuit chips by electron beam accessed lithography. For this reason, the description will be with relation to a semiconductor wafer; however, it is to be understood that the EBAL apparatus herein described can be employed with other target surfaces such as, for example, photoresists where it is desired to electron etch particular pattern configurations into a plurality of target surfaces simultaneously thereby to increase through-put of the EBAL apparatus with minimal cost in capital equipment.

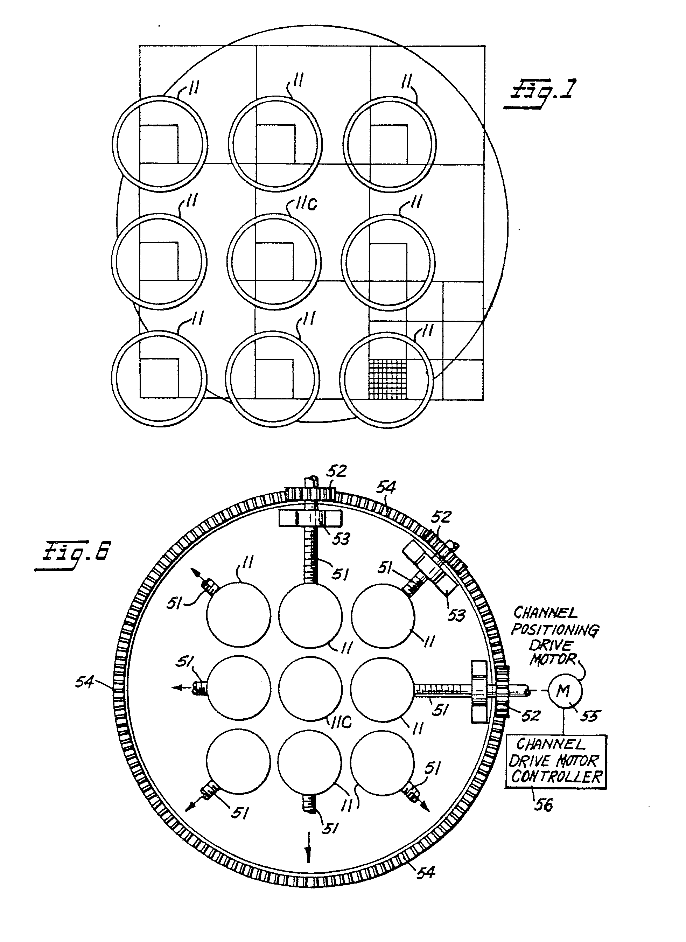

Figure 1 is a top plan view of a multi-channel EBAL apparatus according to the present invention having nine electron beam channels 11. Each electron beam channel is of the array optics type with the array optics being comprised by an assembly of 16×16 array lenslets and associated fine deflector elements as shown in the lowermost right hand electron beam channel. The channels are spaced on 3 cm (1.2 inch) centres and the array lens and deflectors of each channel cover an area of 1 cm (0.4 inch) on a side. The coarse deflector for each channel has a 2.5 cm (1 inch) outside diameter and an inside diameter of 1.9 cm (0.75 inch).

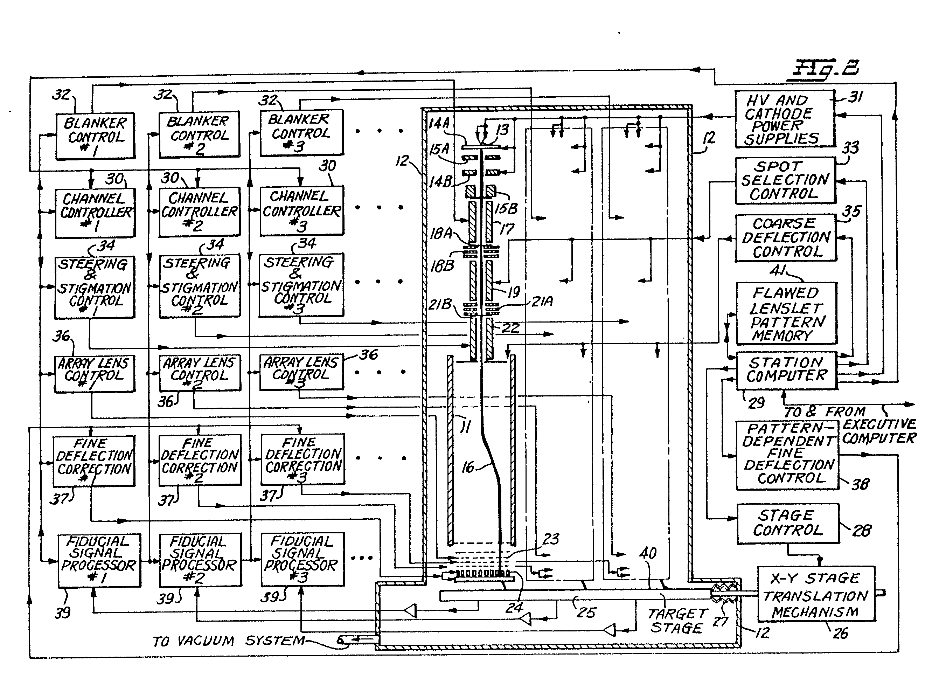

Figure 1 illustrates the multi-channel EBAL apparatus in connection with a 10 cm (4 inch) diameter semiconductor wafer on which a plurality of semiconductor integrated circuit chips are to be formed. With this arrangement, substantially 100% efficient use of the surface area of the semiconductor wafer can be achieved by mechanically stepping the wafer position relative to the central optical axes of the electron beam channels through a 3×3 sub-array of channel fields. By a channel field is meant the field of view of an electron beam channel when projected downwardly onto the target surface of the wafer. The manner in which the wafer is supported on a movable target stage and stepped in an x—y plane normal to the electron beam paths of the electron beam channels through the 3×3 sub-array of channel fields depicted in the lower right hand corner of Figure 1 will be described more fully hereinafter with relation to Figure 2. By thus stepping the target surface in an x—y plane under a 3×3 array of single channel fields, it will be seen in Figure 1 that substantially the entire surface of the semiconductor wafer will be exposed. However, because the efficiency of the corner channels is only about two thirds the through-put achieved with this arrangement will be approximately 9-4/3=8×that of a single electron beam channel run 9 times.

The geometry of the semiconductor wafer shown with the apparatus arrangement of Figure 1, imposes some restriction on the size of chips which can efficiently use the total silicon area of the wafer. Two constraints are involved: (1) a chip might be required to span an integral number of lenslet fields and (2) an integral number of chips must fit between the electron beam channels. The first constraint can be circumvented by appropriate control of the target wafer stepping coupled with lenslet stitching as described in EP—A—0063429 (published 27-10-1982). Table 1 below lists the efficient chip sizes for the geometry of the structural arrangement shown in Figure 1.

TABLE I
100% Efficient chip sizes in mils

| (mls) | (mm) |
|-------|------|
| 400 | 10 |
| 300 | 7.6 |
| 200 | 5.1 |
| 150 | 3.8 |
| 100 | 2.5 |
| 75 | 1.9 |
| 50 | 1.3 |
| 25 | 0.6 |

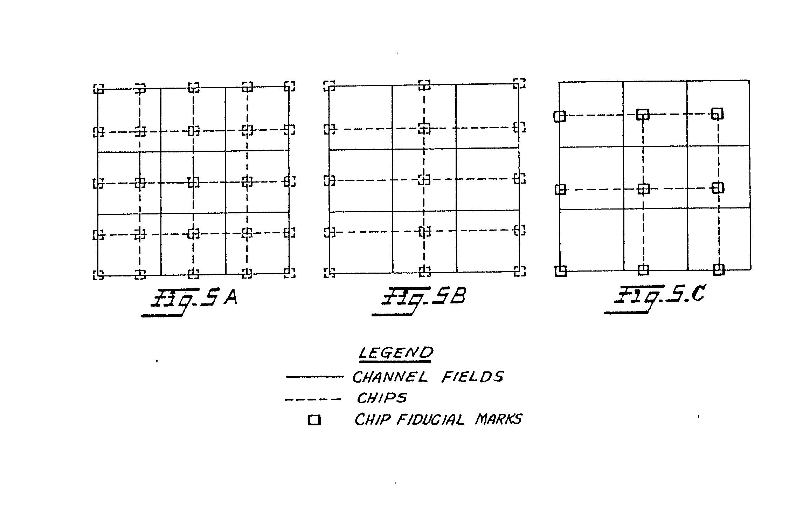

For chip sizes different from those listed in Table I, because of the fixed channel spacing, some silicon area will be wasted between channels as will be described hereinafter with relation to Figure 5. Further, it is possible to allow any chip size to be used at 100% efficiency of silicon usage by providing for variable channel spacing as will be described later in connection with Figure 6. However, for the present purposes it will be assumed that the structural arrangement shown in Figure 1 employs fixed channel spacing between the electron beam channels and that the chip size being fabricated is one of those listed in Table I.

Figure 2 is a combined schematic longitudinal sectional view of a multi-channel (EBAL) apparatus according to the present invention and functional block electric circuit diagram illustrating the essential control circuits used in conjunction with the apparatus. In Figure 2, three of the electron beam channels are shown side by side, with only one of the channels being illustrated in detail. It should be noted that a sectional view taken through the apparatus in a plane at right angles to the plane of the apparatus as shown in Figure 2 would illustrate a similar three channel assembly such that the overall apparatus is comprised of 3×3 or 9 electron beam channels all similarly constructed. The coarse deflector of electron beam channel of Figure 2 is denoted by reference numeral 11 and corresponds to one of the electron beam channels shown in the top plan view of Figure 1. The array of electron beam channels is supported within a common evacuated housing 12 by suitable mechanical supports not shown in Figure 2. Each of the electron beam channels include an electron gun composed of a cathode 13, first and second control grids 14A and 14B and an anode 15A, 15B. The electron gun (hereinafter referred to as 15) produces an electron beam whose path is indicated at 16 which first passes through a set of blanking electrodes 17, a first condenser lens assembly 18A, 18B, a set of spot selection electrodes 19, a second set of condenser electrodes 21A, 21B and thence to a set of steering and stigmation control electrodes 22. After passing through the steering and stigmation electrodes 22, the electron beam enters the coarse deflector assembly 11 which may be constructed and operated in the manner described in US—A—4 142 132. Preferably, however, the coarse deflector 11 is constructed in the manner described in EP—A—0028924. From the coarse deflector 11, the electron beam then enters a selected lenslet of an array lenslet assembly 23 which it passes through to enter an associated fine deflector element 24 which then deflects the electron beam to a desired point on a target surface supported on a movable target stage 25. The array lenslet assembly 23 and fine deflector assembly 24 are preferably of the type described in US—A—4 200 794.

The movable target stage 25 is designed to support on a surface 40 a target surface such as an enlarged semiconductor wafer below the fields of view of the combined 9×9 assembly of electron beam channels as depicted in Figure 1. As already mentioned Figure 1 shows the EBAL assembly designed for optimum use with a 10 cm (4 inch) diameter semiconductor wafer. It is to be expressly understood that the invention is in no way limited to the use of 10 cm (4 inch) diameter wafers but could be used with 12.7 cm (5 inch) or 15.2 cm (6 inch) or any other diameter wafer by appropriate design and spacing between the electron beam channels. The spacing between channels would, of course, be such as to optimize efficient use of the surface of the semiconductor wafer. The enlarged semiconductor wafer target surface is supported on the target stage 25 which is movably positioned within the evacuated housing 12 beneath the field of view of the 3×3 array of electron beam channels. The target stage 25 is mechanically coupled to an x—y stage translation mechanism 26 of conventional, commercially available construction through a vacuum type flexible coupling 27. The x—y stage translation mechanism 26, in turn, is electrically controlled by a movable stage position control circuit 28 that, in turn, comes under the control of a station computer 29. The station computer 29 can be preprogrammed to cause the control circuit 28 to have the x—y stage translation mechanism 26 controllably step the target stage 25 along either the x or y axis of a plane that is normal to the plane of Figure 2 and substantially normal to the electron beam paths of the electron beam channels. In this manner, the target stage 25 can be caused to move the enlarged target wafer as shown in Figure 1 either right or left or up or down so as to move the 3×3 sub-array of channel fields selectively beneath all of the electron beam channels simultaneously. In the position shown in Figure 1, the channel field of the 9 electron beam channels corresponding to the field which is shown in cross hatch to illustrate the 16×16 array lenslet and deflector fields of view, would be centred under the respective electron beam channels in the manner shown. Thereafter, in a preprogrammed manner, the semiconductor wafer would be moved by the target stage 25 for a distance corresponding to the centre-to-centre spacing of the 3×3 sub-array of channel fields so as to bring, for example, the next channel field to the right of those illustrated beneath the field of view of the respective electron beam channels. Thereafter, in a preprogrammed controllable manner, the semiconductor wafer would be stepped through all of the 3×3 sub-array of channel fields by the station computer 29 via the control circuit 28 and the x—y stage translation mechanism 26, the flexible vacuum tight coupling 27 and target stage 25 in accordance with preprogrammed lithography processing steps and patterns so as to cover substantially the entire surface area of the semiconductor wafer by the combined fields of view of all of the parallel operated electron beam channels used in conjunction with the mechanical stepping of the target surface.

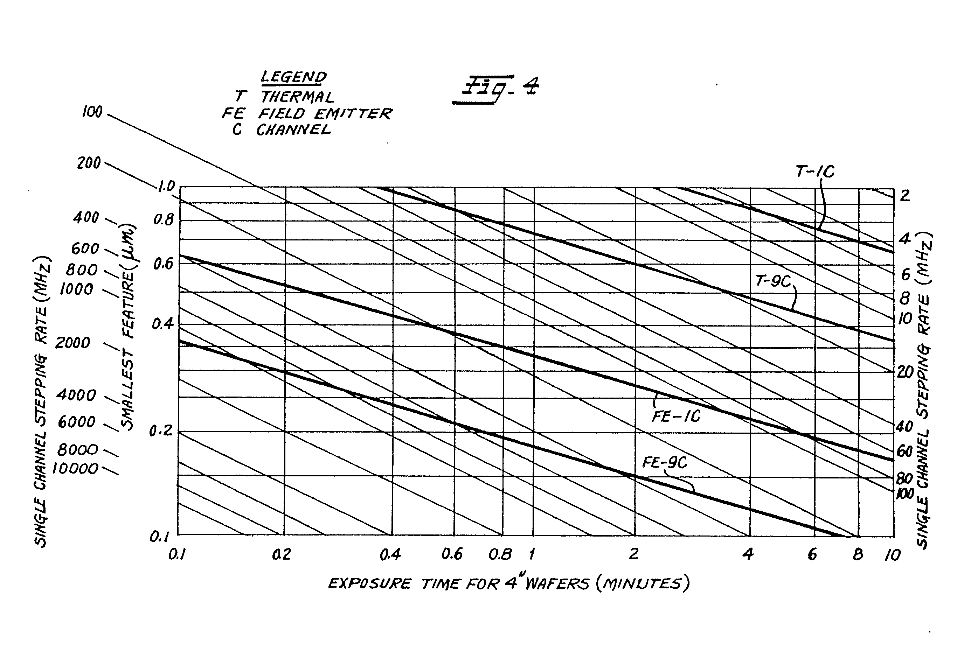

Each of the 3×3 array of electron beam channels shown in Figure 2 should employ a cathode which combines adequate brightness and low operating temperature with long life in a demountable vacuum chamber which may be occasionally exposed to ambient air. Furthermore, the cathode should be designed for periodic replacement in demountable hardware. One suitable cathode would be tungsten having a brightness of approximately $3×10^4$ amperes per square centimetre per sterradian. An even better choice having higher brightness would be a lanthanum hexaboride cathode which could operate the EBAL apparatus at a brightness of about $4×10^5$ amperes per square centimetre per sterradin. A still further possible cathode, as will be discussed hereinafter with relation to Figure 4, would be a field emission cathode as opposed to the two thermal cathodes described above.

Electrical power for the cathode and electron gun of each of the electron beam channels is supplied from a high voltage and cathode power supply 31. The beak blanker electrodes 17 are supplied from an electron beam blanker control circuit 32, the condenser lens assembly 18 and the condenser electrodes 21 are maintained at ground potential and the beam spot size and the shape selection electrode 19 is under the control of a spot selection control circuit 33. The steering and stigmation control electrodes 22 are controlled by a steering and stigmation control circuit 34 and the coarse deflector 11A is under the control of a coarse deflector control circuit 35.

Looking at the lower portion of Figure 2 it will be seen that the array lenslet assembly 23 are under the control of a channel array lens control circuit 36, the fine deflector assembly 24 under the control of associated fine deflection correction circuit 37 as well as a pattern dependent fine deflection control circuit 38 shown on the right hand side of Figure 2. Fiducial signal processing circuits for each of the electron beam channels are shown at 39, and lastly a flawed lenslet pattern memory circuit 41 which works in conjunction with the station computer 29 and controllers 30.

All of the above-listed electron beam channel components and their control circuits are well known in the art and are described in US—A— 4 200 794 and US—A—4 142 132 and EP—A— 0063429. For this reason, a detailed description of each off the components and its manner of operation as well as the construction and operation of its related control circuit or component, is not believed to be required. It should be noted with respect to Figure 2, however, that certain of the control and supply circuits shown on the right hand side of Figure 2 are common to all of the electron beam channels. These are composed of the high voltage and cathode power supply 31, the spot selection control circuit 33, the coarse deflection control circuit 35, the flawed lenslet pattern memory 41, the station computer 29, the pattern dependent fine control circuit 38 and the movable stage position control circuit 28. The control circuits shown on the left hand side of Figure 2 are independently controlled by the individual channel controllers 30 for operation in conformance with the operating characteristics of each of the individual electron beam channels. These are composed of the blanker control circuits 32, the individual channel controllers 30, the steering and stigmation control circuit 34, the channel array lens control circuit 36, the fine deflection correction circuit 37 and the fiducial signal processing circuits 39.

The method of achieving multi-level pattern registration by mapping a stitching calibration grid onto a semiconductor wafer or chip to be processed in the EBAL apparatus, is described more fully in EP—A—0063429 and reference is to be made thereto for a full description of the techniques and procedures employed in achieving required pattern registration and lenslet stitching as described in that application. Briefly. however, a chip registration grid is defined by first producing fiducial marking holes at the corners of each integrated circuit chip in the manner described in EP—A—0063429. Then, by measurement of the position of the fiducial marking holes, a transformation can be computed in a computer which will, in turn, map the chip registration grid into a lenslet stitching calibration grid by means of which patterns are actually written on the target surface. With this method, chip by chip corrections can be made for semiconductor wafer insertion errors (translation or rotation and wafer dimensional changes due to expansion or quadrilateral distortion. Prior to placing an EBAL apparatus according to the present invention in operation, it is necessary first to form the necessary chip registration grids as described briefly above.

The next problem which has to be considered in the subject apparatus is any inaccuracy in lenslet stitching and the pattern registration which can occur due to the non-orthogonalangle which the electron beams make at the target surface due to the fact that exposure to the electron beams is made on the surface of workpieces which are not inserted at exactly the same height (distance from the electron source) as the original lenslet stitching calibration grid employed to form the chip registration grid. This problem is explained more fully in EP—A—0063429 and reference is made thereto for a more detailed description of the problem and the manner in which it is overcome by appropriate correction.

Another problem which must be considered in any practical apparatus, is the occurrence of a flawed lenslet in any one of the lenslet arrays employed in any one of the plurality of electron beam channels. Since the failure of any lenslet in any one of the lenslet arrays would result in the production of a bad integrated circuit chip, the chip yield would be reduced substantially if means were not provided for overcoming the existence of any such flawed lenslets. The flawed lenslet problem can be solved by permuting a semiconductor target wafer between two stations in a manner such that any portion of a target surface which previously had been exposed to the field of view of a flawed lenslet, is selectively and in a program controlled manner permuted to a new position where it is subjected to the field of view of a good lenslet and the target then subsequently exposed to the electron beam in accordance with the pattern movement of the beam required for that particular area of the target. The manner in which permutation of the target wafers between two positions to correct for the existence of any flawed lenslets again is described more fully in EP—A—0063429 and reference is made thereto for a full description of the techniques required.

Prior to placing an EBAL apparatus according to the present invention in operation, it is first necessary to form appropriate lenslet stitching calibration grids for each individual electron beam channel in the EBAL apparatus as taught in EP—A—0063429. After insertion of a target wafer on the movable head, chip registration grids would be formed on the surface of the wafer along the boundaries of each integrated circuit chip site in the manner taught by EP—A— 0063429.

In operation, after positioning of the target surface in a preprogrammed manner by the target stage 25, the electron beams produced by the electron gun of each of the 9 electron beam channels first passes through the set of blanking electrodes 17 which are positioned to deflect the electron beam off an aperture and onto an opaque plate for cutting off or blanking the beam of each channel before it reaches the target surface. When the preprogramming calls for electron writing on the target surface, blanking is discontinued, and the individual electron beams are allowed to pass through the beam spot selection electrodes 19 for establishing the size and shape of the electron beam spot. The beam then passes through the steering and stigmation control electrodes 22 for aligning the electron beam with the axis of the coarse deflector 11 for deflecting the electron beam 16 to the entrance of a particular lenslet in the array lenslet assembly 23. Because the coarse deflectors 11 of all of the electron beam channels are under the common control of the coarse deflection control circuit 35, the electron beams of all of the electron beam channels will be deflected to corresponding ones of an array lenslet in the array lenslet assemblies. After passing through the array lenslet assembly, the electron beams will pass through corresponding associated ones of the fine deflectors which likewise are under the common control of the pattern dependent fine deflection control circuit 38. As a result, the electron beams will be caused to write upon corresponding target surfaces of the semiconductor wafer simultaneously. Referring again to Figure 1, if it is assumed that the 16×16 array lenslet and fine deflector assemblies have a sufficient field of view to cover entirely one semiconductor integrated circuit chip, it will be seen that by the above described EBAL apparatus and method of operation, 9 semiconductor integrated circuit chips can be treated simultaneously as opposed to a single beam system as described in EP—A—0063429.

The through-put of the multiple channel EBAL apparatus shown and described with relation to Figures 1 and 2 is determined primarily by three factors: exposure time, and wafer positioning time between exposure fields and mechanical transport time to and from the exposure station. Table II below lists these factors with relation to the stepping rate of a single channel EBAL apparatus so that the stepping rate for a 9 channel EBAL apparatus can be obtained by multiplying the number of channels times the assumed stepping rate of 20 MHz at which a single channel of the apparatus is designed to operate.

TABLE II
Determination of through-put for 0.5 micrometer minimum feature size

| Activity | Time required (seconds) |
| --- | --- |
| Exposure | 30 |
| Wafer Positioning | 15 |
| Transport | 5 |
| Overhead (software, electronics settling) | 22 |
| Total Time | 72 |
| Through-put (No. of 10 cm (4-inch) wafers/hour) | 50 |

The relationship between resolution, exposure time, and beam stepping rate is depicted in Figure 4 where the stepping rate is calculated on the basis of a single channel EBAL apparatus. As noted above a stepping rate of 20 MHz is designed into the 9 channel EBAL apparatus shown in Figure 2 for each electron beam channel so that an equivalent rate of 180 MHz is obtained for the overall EBAL apparatus. From Figure 4 it will be seen that for an exposure time of 0.50 minutes for a minimum feature size of 0.5 μm, this value of exposure time is entered in Table II to obtain the total time which is required in the processing of a single chip by a single channel EBAL apparatus.

Because exposure time depends on many factors, it is difficult accurately to predict precisely what the exposure time will be for any given integrated circuit chip having minimum feature sizes different than the 0.5 μm minimum feature size assumed. However, ranges and goals can be established. The principal parameters which determine exposure time are listed in Table III as well as the values assumed to calculate the dependence of the smallest feature size on exposure time as depicted in Figure 4.

## TABLE III
### Principal parameters which determine exposure time

| Parameter | Assumed value (used in Fig. 4) |
|---|---|
| Resist sensitivity (C/cm$^2$) | 5 |
| Gun brightness (amp/cm$^2$-sr) | $2\times10^6$ (thermal LaB$_6$) |
| | $2\times10^8$ (field emission) |
| Fine deflection stigmation | 4×increase in current |
| Variable Spot | 1:4 (linear dimension) |
| Exposed area | 10% smallest spot |
| | 15% largest spot |
| | 25% total |
| Number of channels | 1 or 9 |
| Stepping rate for writing spot | See nomograph, Figure 4 |

Four different EBAL apparatus are depicted in Figure 4 as examples. In the case of a thermal cathode-single channel (T-1C), this system is calculated using different programs which are known to describe array optical systems quite accurately. These array optical systems provide a sharp profile spot of fixed size, therefore, the T-1C system is a well established bench mark for which the performance of other systems can be measured. The 9-channel system T-9C, is obtained by simply shifting T-1C to shorter exposure time by a factor of 8 (not 9 because the corner channels are not 100% efficient as mentioned earlier).

The field emission cathode system, FE-1C is obtained by shifting T-1C to shorter exposure time by the ratio of cathode brightnesses for field emission and thermal cathodes, i.e. $2\times10^8/2\times10^6=100$ from Table III. Finally, the FE-9 system is obtained by reducing the exposures of FE-1C by a factor of 8.

In addition to producing the required feature size (assumed to be 0.5 μm in Table II) within an acceptable exposure time, the stepping rate of the writing electron beam spot must fall within a practical range. To calculate the electron beam stepping rate, the relationship between the smallest feature and the smallest electron beam spot obtainable, must be clearly defined. It is assumed that these are equal if the spot profile is sharp; however, for a Gaussian profile, the smallest feature is 3 to 4 times spot diameter in size. In Figure 4 it is assumed that the profile is sharp and, therefore, that the smallest feature and the smallest spot are equal. With these assumptions, the stepping rates corresponding to 10% coverage of the smallest feature are obtained from the nomograph superimposed on Figure 4. These rates have been calculated by neglecting the time required for 15% coverage with the largest spot (feature).

It is desired that the multi-channel EBAL apparatus according to the present invention be capable of processing integrated circuit chips wherein the smallest feature falls between 0.5 and 0.75 μm. In addition, the apparatus has an exposure time of 0.5 to 1 minute for integrated circuit chips processed on 10 cm (4-inch) semiconductor wafers. The cross-hatched nomograph area in Figure 4 depicts these operating characteristics. Within the framework of the assumptions used in developing Figure 4, such a range of operations appears to be unaccessible to EBAL apparatus which employ thermal emitters but is fully within the capability of EBAL apparatus employing field emitters. In such EBAL apparatus, the electron beam stepping frequency is seen to be from approximately 30 to 100 MHz for a single channel EBAL apparatus. Dividing by 8 for a 9-channel EBAL apparatus gives the range of approximately 4 to 10 MHz stepping rate for the 9 channel EBAL apparatus and of course the use of the multiple channels also reduces the number of mechanical steps required of the translatable stage from $9\times60=145$ to 16.

In addition to the above considerations, in actual integrated circuit development manufacture, it is desirable to change feature sizes in small increments or even continuously. With only fixed electron beam spot sizes, incremental changes of feature sizes is possible by overlapping exposures. However, the resulting exposure time is increased and further the technique is limited by proximity effects. It is a feature of the subject invention to provide a continuously variable spot size, or at least a sufficient number of different fixed size electron beam spots through the medium of the spot selection control circuit 33 and spot size selection electrodes 19, to allow small incremental changes in feature size of the integrated circuit chips being processed.

Returning to Table II, in order to calculate the time required for wafer positioning, the movable stage motion must be considered. This motion is subject to three design constraints; accuracy, speed and stability. Because the need for extremely accurate absolute positioning is reduced by the use of computer correction, *via* the fiducial marking signals, the x—y stage translation mechanism 26 is not limited by instrumentation requirements such as pulse-counting. However, as speed is increased, the locally dissipated energy increases rapidly, adding to the thermal stability problem. For example, a preloaded nut-screw assembly generates considerable heat which, in steel, is particularly difficult to dissipate because of full thermal conductivity of the material. Consequently, a suitable x—y stage translation mechanism for the target stage 25 is either one which is loosely thermally connected to the target stage 25, such as *via* a 3-ball detent positioning platen or a continuous drive acting through a web or the line contact of a drive wheel which would serve as a heat sink. Because these types of mechanisms contain some dead zone and compliance, they cannot be used in extremely tight servo loop controls employing the fiducial marking signals. However, for the EBAL apparatus according to the present invention, a suitable performance figure of merit would be between 0.1 g to 0.3 g acceleration. For the 0.4 transport distance required between respective fields of view of the electron beam channels, this figure amounts from 2.8 seconds to 1.6 seconds transport time. Thus, the amount entered into Table II is 9×1.6=15 seconds.

In order to complete the through-put calculations for an EBAL apparatus according to the present invention as shown in Table II, five seconds has been allowed for moving the semiconductor wafer in and out of the evacuated housing and onto the target stage 25. Also, some overhead time proportional to exposure time has been allotted in order to take account of software and electronic control circuit settling times. Taking all of these times into consideration, Table II shows the projected through-put of fabrication of semiconductor integrated circuit chips on 10 cm (4 inch) target wafers to be of the order of 51 target wafers per hour.

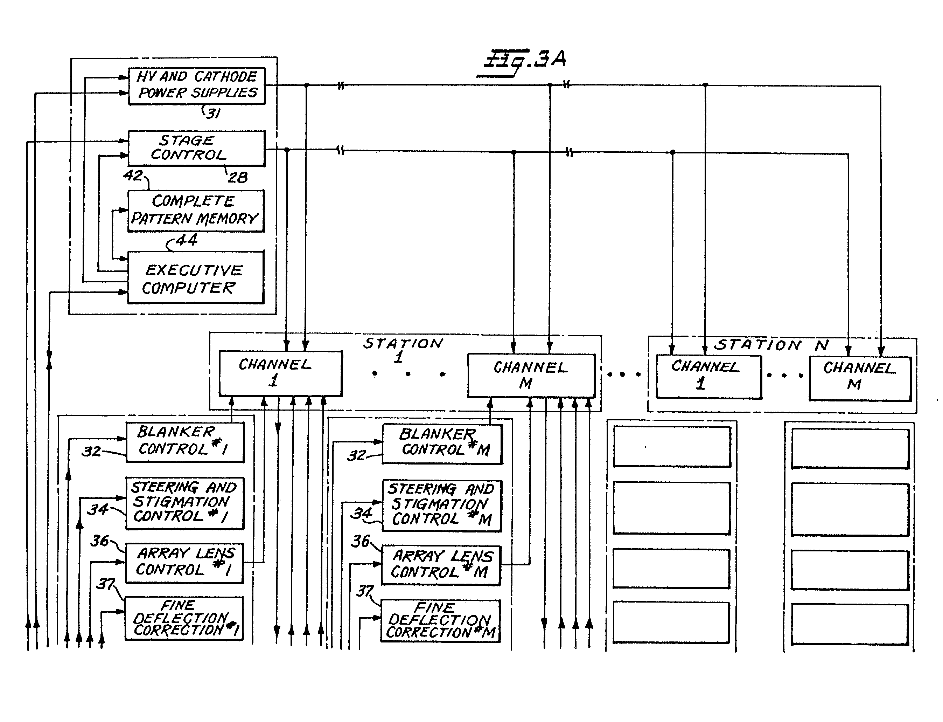

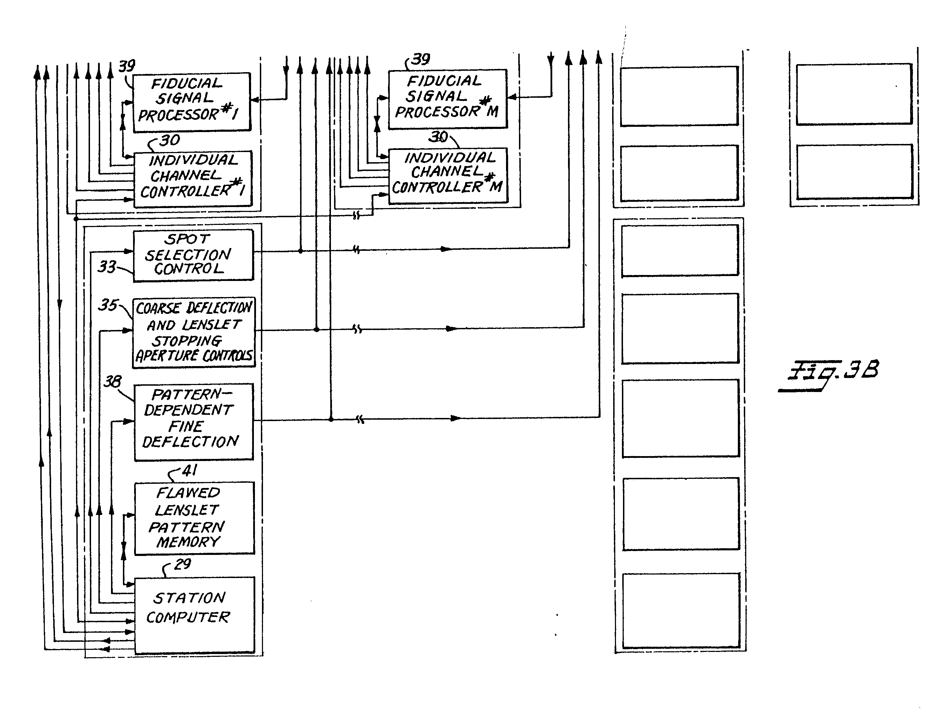

It is technically possible and economically advantageous to increase the through-put of an EBAL installation by using multiple stations where each station comprises a multiple channel EBAL apparatus of the type shown in Figures 1 and 2, and where all of the stations are operated in parallel under the supervision of a system executive computer. The economic advantage of such multiple, multi-channel EBAL apparatus in an increased capacity system results from a significant sharing of the vaccum systems, the transport system for the target wafers and the electronic hardware as shown in Figures 3A and 3B of the drawings. In Figures 3A and 3B, a multi-station EBAL apparatus according to the present invention is shown where there are from 1 to N stations where N is a number determined by the desired through-put of the overall EBAL apparatus. Each station has from 1 to M channels where again M is any desired number determined by the desired through-put from each station. If the station is to have 9 channels as was described with relation to Figures 1 and 2, then the number M would equal 9 and there would be a number of N stations each having M=9 channels in the overall EBAL apparatus. Similar to the EBAL apparatus of Figure 2, each electron beam channel of the system will have its individual blanker control circuit 32, steering and stigmation control circuit 34, array lens control circuit 36, fine deflection correction circuit 37, and fiducial signal processing circuit 39 all interconnected with and controlled by or helping to control the individual channel controller 30. Further, each electron beam channel also will have supplied to it control signals from a spot selection control circuit 33, a coarse deflection control circuit 35, a pattern dependent fine deflection circuit 38 and a flawed lenslet pattern memory 41 all of which are shared in common through the station computer 29 with other electron beam channels in the station. Since all stations would be fabricated in the same manner, a description of other channels in the station or for that matter description of the other stations is deemed unnecessary.

In order to coordinate operation of all of the stations, the station computers of all of the stations are under the control of a master system executive computer 44 which serves all of the stations. It is assumed that all of the stations will be fabricating a mass produced semiconductor integrated circuit chip hence a master complete pattern memory 42 can be provided at the system executive computer 44 for controlling all of the stations which in turn control all of the electron beam channels. This also makes it possible for the system installation to have a single master control circuit 28 and a single master power supply 31 supplying all of the channels of all of the stations thereby to economize on the hardware required in the overall EBAL apparatus.

Where using EBAL apparatus of the type shown and described with relation to Figures 1—4, certain natural semiconductor integrated circuit chip sizes will be the most productive to manufacture due to the discrete spacing of the lenslets within the array lenslet assembly of each electron beam channel, the limited size of the electron beam channel fields of view, and the discrete spacing between the electron beam channels. Thus, it is most convenient to employ the EBAL apparatus in connection with integrated circuit chip dimensions which are equal to an integral number of lenslets, because then the control programs for each lenslet would be the same for all chips. However, in any practical EBAL apparatus this requirement cannot always easily be met and is not necessary if it is recognised during setup and the software controlling the EBAL apparatus and system structured such that the chips do not have to fit within an integral number of lenslets.

A second natural integrated circuit chip size which would be convenient would be to make the chip size commensurate with the size of the field of view of the electron beam channels. This constraint would result in the simplest of chip fiducial marking signal grid fabrication, calibration grid and chip registration grid fabrication and would result in the minimum number of mechanical steps for the movable target stage. Examples of various other relationships between the integrated circuit chip size and the size of the fields of view of the electron beam channels are illustrated in Figure 5.

In Figure 5A chips which are smaller than but not commensurate with the channel fields are illustrated. In this situation, the fiducial holes required to derive the fiducial marking signals would be at the corners of the chips and 4×4 instead of 3×3 mechanical movement steps of the target stage are required to write the target wafer. Thus, chips which are smaller than the size of the channel field can be written at the expense of more mechanical movement of the movable target stage.

Figure 5B illustrates a situation wherein the semiconductor integrated circuit chip size exceeds the size of the field of view of the electron beam channels in one dimension only. In this situation the fiducial holes are chosen such that only 3×3 mechanical steps are required along the long dimension but more steps are required along the short dimension similar to Figure 5A. Another requirement is that placement of fiducial holes within the working edge of the chip would be required.

Figure 5C illustrates a situation where the integrated circuit chips are larger than the channel field of view of both dimensions. In this situation it may be possible to write the target wafer with only 3×3 movement; however, the wafer can only be written by placing fiducial holes within the working area of the chips.

Summarizing the above considerations, it will be appreciated that a natural chip size arises from the mechanical constraints of the EBAL apparatus whereby it is most desirable that an integral number of integrated circuit chips fit between the electron beam channels. As a result, for certain chip sizes, the constraint imposes less than 100% utilization of the surface area of the target wafer. For the particular preferred multi-channel EBAL apparatus described in this application, the 100% efficient chip sizes are listed in Table I.

If it is desired to obtain a full 100% utilization of the surface of the target wafer for any size integrated circuit chip being processed by a multi-channel EBAL apparatus according to the present invention, this can be achieved by providing a small mechanical adjustment between the electron beam channel spacing in the manner shown in Figure 6. With the arrangement shown in Figure 6, a channel spacing adjustment of only 3.8 mm (150 mils) would be sufficient to make all chip sizes 100% efficient in target surface utilization. Because this adjustment as illustrated in Figure 6 does not require great mechanical precision and can be done slowly and rarely whenever adapting the EBAL apparatus to a new and different size integrated circuit chip size, there is no practical difficulty encountered in providing such additional flexibility provided the need for such flexibility is economically justified.

In Figure 6, the outer electron beam channels 11 surrounding a centre channel 11C are moved in and out radially from a common centre position by means of lead screws 51 which are simultaneously turned by means of a rack and pinion 52 supported on suitable bearing blocks 53. All of the rack and pinions 52 and hence lead screws 51 are moved simultaneously by rotating a ring-shaped rack 54 by a column positioning drive motor 55 under the control of a column drive motor controller 56. The column drive motor controller 56 would be included along with the common stations controls in the EBAL apparatus of Figure 2 or Figure 3A and 3B. By properly designing the pitch of the lead screws 51, the electron beam channels can be moved in and out so as to maintain a regular rectangular array while providing variable spacing between the centres of the electron beam columns. In the case of larger than 3×3 multi-channel EBAL apparatus, where there would be radially aligned electron beam channels that would have to be moved, a differential screw arrangement would be required in order to provide the required position movement of the electron beam channels. The accuracy of movement required is determined by the electronic capture range of the fiducial marking signal deriving system which is known to be in the order of 0.03 mm to 0.1 mm (1 to 3 mils). Also, it should be noted that movement of the electron beam channels does not occur very often (only when it is necessary to adapt the installation to a new and different size integrated circuit chip) and thus the movement can be effected at slow speeds. Hence, a digital stepping motor inside the evacuated housing 12 and under the control of the same computer program which writes patterns on the chips could be used.

With a multi-channel EBAL apparatus such as shown in Figure 6 where the positions of the electron beam channel can be moved, let the parameters be defined as follows:

S=lenslet spacing
M=lenslets per chip side
N=chips between channels
MN=lenslets between channels
W=chip size
=S×M mils

For an EBAL apparatus where the lenslet spacing S=0.025, all M between 1 and 12 (maximum chip size of 7.6 mm (300 mils) and N=48 such that MN is as close to 48 as possible, the results shown in Table IV can be obtained.

From Table IV, it will be seen that all integrated circuit chips between the sizes of 0.6 mm to 7.6 mm (25 and 300 mils) on a side tend to be processed in increments of 0.6 mm (25 mils) with 100% efficiency of silicon surface utilization if the electron beam channel spacing is varied over a range of 50−44=6 lenslets or a distance of 6×0.6=3.6 mm (6×25=150 mils).

TABLE IV

| M | N | MN | W (mils) | W (mm) |
|---|---|---|---|---|
| 1 | 48 | 48 | 25 | 0.6 |
| 2 | 24 | 48 | 50 | 1.3 |
| 3 | 16 | 48 | 75 | 1.9 |
| 4 | 12 | 48 | 100 | 2.5 |
| 5 | 9 | 45 | 125 | 3.2 |
| 6 | 8 | 48 | 150 | 3.8 |
| 7 | 7 | 49 | 175 | 4.4 |
| 8 | 6 | 48 | 200 | 5.1 |
| 9 | 5 | 45 | 225 | 5.7 |
| 10 | 5 | 50 | 250 | 6.4 |
| 11 | 4 | 44 | 275 | 7.0 |
| 12 | 4 | 48 | 300 | 7.6 |

**Claims**

1. A multi-channel electron beam array lithography apparatus comprising a plurality of parallel operated electron beam channels of the array optics type (11) each of which is of the fly's eye type having an electron gun (13, 14A, 14B, 15A, 15B) for producing an electron beam, an array lenslet assembly (23), a respective fine deflector assembly (24) and a coarse deflector (11) for selectively directing the electron beam to a desired array lenslet within the array lenslet assembly and its respective fine deflector which thereafter directs the electron beam to a desired point on a target surface, and an evacuated housing (12) characterised in that the evacuated housing encloses all of said electron beam channels, and in that said apparatus further comprises a common movable stage (25) for supporting the target surface below the electron beam channels and for moving the target surface relative to all the electron beam channels, and target position control means (28) for automatically moving said common movable stage (25) in a preprogrammed manner whereby substantially the entire surface area of the target surface can be brought under the combined view of the electron beam channels, the common movable stage (25) being selectively movable in an x—y plane that is substantially normal to the electron beam channels by an automatically controlled x—y translation mechanism (26) under the control of said target position control means (28) the translation mechanism being mechanically coupled to the movable stage.

2. An apparatus as claimed in claim 1 characterised by a flexible and vacuum tight coupling (27) mechanically coupling the translation mechanism (26) to the common movable stage (25).

3. An apparatus as claimed in claim 1 or 2 characterised in that one or more of lenslets and/or associated fine deflector in one of the array lenslet assemblies (23) may be flawed, said target position control means (28) comprising means for selectively permuting the target surface on which an electron beam impinges during successive exposures of the surface to the electron beam whereby the effect of a flawed lenslet can be overcome by transposition of the area of the target surface previously under the field of view of a flawed lenslet to a new location where it is subject to the field of view of a working lenslet, fiducial marking signal producing means (39) being provided to produce fiducial marking signals for use in stitching together the boundary of the field of view of adjacent lenslets on the target surface and for re-registration of the target surface after permutation between the same or different electron beam channels, the mapping memory means (41) being provided for mapping the location of areas on the target surface which are subject to the field of view of a flawed lenslet and storing the location of flawed lenslet subjected area of the target surface for subsequent readout and use with the fiducial marking signals for controlling operation of the electron beam following permutation of the target surface to a new location where the flawed lenslet subjected areas are subject to the field of view of a working lenslet.

4. Apparatus as claimed in claim 3 characterised in that each electron beam channel further includes an electron gun power supply (31) connected to the electron gun (13, 14A, 14B, 15A, 15B), electron beam blanking electrodes (17) supplied by an electron beam blanking control means (32) for blanking the electron beam prior to its passage through the channel, an electron beam spot size selection optical system (19) under the control of an electron beam spot size selection control means (33) for controlling the cross-sectional dimensions of the electron beam used to perform electron beam lithography, an electron beam stepping deflector assembly (22) under the control of an electron beam stepping control means (34) a stigmator under the control of a stigmation control means (34) for controlling electron beam astigmatism and a coarse deflection control (36) connected to and controlling operation of the coarse deflector (11), an array lenslet focus control means (36) connected to and controlling excitation of the array lenslet assembly (23), a fine deflector control means (38) connected to and controlling excitation of the fine deflector assembly (24) for controlling fine deflection of the electron beam after passage through a selected one of the array lenslets, a fine deflection correction control (37), and a station computer (29) and an individual channel controller (30) responsive to the fiducial marking signals for controlling operation of the electron beam channels in common in conjunction with the target position control means.

5. An apparatus as claimed in claim 4 when dependent upon claim 4 characterised in that said target position control means (28) is arranged to be indirectly under the control of said mapping memory means (41) via the station computer (29) and the individual channel controller (30).

6. An apparatus as claimed in claim 4 or 5 characterised by including fiducial signal processing circuit means (39) for shaping and amplifying the fiducial marking signals, the station computer (29) and the individual channel controller (30) are responsive to the fiducial marking signals while controlling operation of the electron beam channels.

7. An apparatus as claimed in any preceding claim characterised by including means (Figure 6) for mechanically moving the centre axis position of at least the outer arranged electron beam channel or channels relative to each other in order to accommodate different sized surface area target surfaces within the housing (12).

8. An apparatus as claimed in claim 4 or any of claims 5 to 7 when dependent thereon characterised by including column position drive means responsive to the station computer (29) for automatically mechanically moving the centre axis of the electron beam channels to a desired position relative to the target surface in a preprogrammed manner.

9. An apparatus as claimed in any preceding claim characterised by including a pattern registration grid formed on or near the target surface for identifying the boundaries of the field view of the respective lenslets within each array lenslet assembly (23) as well as the boundaries of the field of view of each array lenslet assembly.

10. An apparatus as claimed in any preceding claim characterised by including the target surface which is the surface of an enlarged semiconductor wafer on which a plurality of semiconductor integrated circuit chips are to be formed.

11. An apparatus characterised by comprising a plurality of multi-channel electron beam array lithography stations each consisting of apparatus as claimed in any preceding claim and a system executive computer (44) for controlling operation of the station computers (29).

12. A method of operating a multi-channel electron beam array lithography apparatus as claimed in any preceding claim having a plurality of electron beam channels of the array optics type contained within a common evacuated housing (12), each of said channels comprising an electron gun (13, 14A, 14B, 15A, 15B) for producing an electron beam, an array lenslet assembly (23), an array fine deflector assembly (24), and a coarse deflector assembly (11) interposed between the electron gun and the array lenslet assembly for selectively directing the electron beam to a desired array lenslet of the array lenslet assembly and its respective fine deflector which directs the electron beam to a desired point on a target surface, said method comprising: operating all of said electron beam channels simultaneously in parallel in response to common pattern controlled deflection signals applied in common to the respective coarse and fine deflector assemblies (11, 24) of each electron beam channel thereby to write on different predetermined areas of the target surface simultaneously.

13. A method as claimed in claim 12 characterised in that the target surface is the surface of an enlarged semiconductor wafer on which a plurality of semiconductor integrated circuit chips are to be formed and the surface area of each chip is substantially equal to the field of view of one of the electron beam channels or some integral multiple thereof.

14. A method as claimed in claim 12 or 13 characterised in that the target surface is selectively moved in an x—y plane that is substantially normal to the electron beam channels.

15. A method as claimed in any of claims 12 to 14 characterised in that one or more of the plurality of electron beam channels has an array lenslet assembly one or more of which may be flawed, the method further including deriving fiducial marking signals from a pattern registration grid formed on or near the target surface for identifying the boundaries of the field of view of a respective array of micro-lenslets on the target surface for use in stitching together the combined fields of view of the array lenslet assemblies sufficient to cover a desired area of the target surface to be exposed, exposing the desired area of the surface to the electron beam, mapping in a computer memory the location of any spot on the exposed target surface area which was subject to the field of view of a flawed lenslet in an array lenslet assembly while blanking operation of the flawed lenslet, permuting the physical position of the exposed target surface area to a new physical position subject to the field of view of a different set of array lenslets whose combined field of view again covers the desired area of the target surface to be exposed, deriving from the computer memory retrace control signals for controlling operation of at least the coarse deflector and fine deflector assembly of the electron beam channel for redirecting the electron beam back to the previously unexposed spot caused by the flawed lenslet, and retracing the electron beam over such spot in accordance with the master pattern specifications for the spot location on the target surface whereby increased yield from the EBAL system is obtained.

16. A method as claimed in claim 15 characterised by comprising employing the fiducial marking signals derived from the pattern registration grid for controlling reregistration of the target surface after removal, partial processing and reinsertion of the target surface in the same or a different electron beam array lithography station by automatically controlling positioning of the target surface with the fiducial marking signals relative to the array lenslets and fine deflector assembly to correct for rotation, expansion, linear displacement, and other similar target insertion errors as well as target warping or dimensional changes due to intermediary processing of the target, thermal expansion, expansion gradients, differential expansion between the array lenslet assembly and the target and other like errors in positioning of the target surface after its removal, partial processing and reinsertion in the same or a different EBAL station.

17. A method as claimed in any of claims 12 to 16 characterised by further comprising fabricating a lenslet stitching calibration grid having formed thereon a grid-like network of fiducial marking elements, using said calibration grid to derive fiducial marking signals indicative of the boundaries of the field of view of the individual elements of the array lenslet assembly of each electron beam channel, and using said fiducial marking signals to control the respective electron beam channels so as to stitch together the individual fields of view of the elements in the array lenslet assembly of each electron beam channel, and to stitch together the combined fields of view of the array assemblies to cover a desired area of a target surface to be exposed to the electron beams and which is greater in the surface area than the area covered by the field of view of an individual array lenslet element, the lenslet stitching calibration grid having formed thereon fiducial marking elements at positions corresponding to at least a plurality of points along the boundary of the field of view of each lenslet element of the array lenslet assembly of each electron beam channel.

18. A method as claimed in claim 17 characterised in that the target surface is a semiconductor wafer onto which a plurality of integrated circuit chips are to be formed employing electron beam lithography and further comprising forming fiducial marking elements on at least a plurality of points on the boundaries of each chip to thereby form chip registration grids, measuring the x—y coordinate positions of the chip registration grid fiducial elements for mapping purposes, and transforming the chip registration grid mapped coordinate positions into corresponding positions on the lenslet stitching calibration grid by means of which patterns are actually written on the chips with the electron beam channels of the array optics type whereby chip by chip corrections can be made for semiconductor wafer insertion errors due to translation or rotation and for wafer dimension changes due to expansion or quadrilateral distortion.

19. A method as claimed in claim 17 or 18 characterised in that increased and greater accuracy can be attained by the addition of more fiducial marks along the boundaries of fields of view of the array lenslet assemblies on the lenslet stitching calibration grid in order to provide more measurements with which to determine the values of additional constants used in the mathematically defining the lenslet stitching calibration grid.

20. A method as claimed in any of claims 17 to 19 characterised by further including correcting for height displacement differences due to difference between vertical placement of lenslet stitching calibration grid and the target surface along the electron beam path within the electron beam channel.

21. A method as claimed in any of claims 12 to 20 characterised in that the surface area of the target surface is substantially equal to some integral multiple of the target surface area viewed by the electron beam channel, said method including mechanically moving the target surface selectively in a preprogrammed manner relative to the central axes of the plurality of the electron beam channels whereby substantially the entire surface area of the target surface can be brought under the combined view of the plurality of the electron beam channels.

22. A method as claimed in any of claims 12 to 21 characterised in that the method is conducted simultaneously in a plurality of parallel operated electron beam array lithography apparatus with each EBAL apparatus comprising a plurality of electron beam channels and having a high voltage power and electron gun power supply, pattern position dependent dynamic focus, stigmation, deflection, blanking and electron beam spot size selection controlled in common by an overall system executive computer and chip registration, lenslet stitching rotational and translational movement control, flawed lenslet mapping memory and control and coarse deflection for flawed lenslet mapping memory and control and coarse deflection for flawed lenslet correction memory and control all individually controlled for each EBAL apparatus by an individual station computer either alone or in conjunction with an individual channel controller.

23. A method as claimed in any of claims 12 to 22 characterised in that there are a plurality of parallel operated electron beam array lithography stations with each electron beam array lithography station comprising a plurality of electron beam channels and further including a system executive computer for controlling the operation of certain components of all of the array-optics type electron beam channels of the plurality of electron beam array lithography stations in common and a plurality of individual station computers each respectively associated with an individual electron beam array lithography station and an individual electron beam channel controller for controlling the operation of the remaining components of its respective electron beam tube alone or in conjunction with each other.

24. A method as claimed in any of claims 12 to 23 characterised by including mechanically moving the centre axis position of at least the outer arranged electron beam channels relative to each other in order to accommodate different sized surface area target surfaces within the common evacuated housing.

## Patentansprüche

1. Vorrichtung zur Mehrkanal-Elektronenstrahlmatrix-Lithographie mit einer Anzahl von parallel betriebenen Elektronenstrahlkanälen (11) vom Matrixoptik-Typ, die jeweils vom Fliegenaugetyp sind und ein Elektronenstrahlerzeugungssystem (13, 14A, 14B, 15A, 15B) zur Erzeugung eines Elektronenstrahls, eine Teillinsenmatrix-baugruppe (23), eine jeweilige Feinablenk-baugruppe (24) und eine Grobablenkeinrichtung (11) aufweisen, die selektiv den Elektronenstrahl auf eine gewünschte Matrix-Teillinse in der Teillinsenmatrixbaugruppe und auf die jeweilige Feinablenkeinrichtung lenkt, die darauffolgend den Elektronenstrahl auf einen gewünschten Punkt auf einer Zieloberfläche lenkt, und mit einem Vakuumgehäuse (12), dadurch gekennzeichnet, daß das Vakuumgehäuse alle Elektronenstrahlkanäle umschließt, daß die Vorrichtung weiterhin einen gemeinsamen beweglichen Objektträger (25) zur Halterung der Zieloberfläche unterhalb der Elektronenstrahlkanäle und zur Bewegung der Zieloberfläche gegenüber allen Elektronenstrahlkanälen, und Zielpositions-Steuereinrichtung (28) zur automatischen Bewegung des gemeinsamen beweglichen Objektträgers (25) in einer vorprogrammierten Weise umfaßt, wodurch im wesentlichen der gesamte Oberflächenbereich der Zieloberfläche unter des kombinierte Blickfeld der Elektronenstrahlkanäle gebracht werden kann, wobei der gemeinsame bewegliche Objektträger (25) selektiv (25) selektiv in einer im wesentlichen senkrecht zu den Elektronenstrahlkanälen liegenden x—y-Ebene mit Hilfe eines automatisch gesteuerten x—y-Translationsmechanismus (26) unter der Steuerung der Zielpositions-Steuereinrichtungen (28) beweglich ist, und wobei der Translationsmechanismus mechanisch mit dem beweglichen Objektträger gekoppelt ist.

2. Vorrichtung nach Anspruch 1, gekennzeichnet durch eine flexible und vakuumdichte Kupplung (27), die den Translationsmechanismus (26) mechanisch mit dem gemeinsamen beweglichen objektträger (25) koppelt.

3. Vorrichtung nach Anspruch 1 oder 2, dadurch gekennzeichnet, daß eine oder mehrere Teillinsen und/oder die zugehörige Feinablenkeinrichtung in einer der Teillinsenmatrixbaugruppen (23) beschädigt sein kann, daß die Zielpositions-Steuereinrichtungen (28) Einrichtungen zum selektiven Vertauschen der Zieloberfläche umfassen, auf die der Elektronenstrahl auftrifft, während die Oberfläche aufeinanderfolgend dem Elektronenstrahl ausgesetzt wird, so daß die Auswirkung der beschädigten Teillinse durch Verschieben des Bereiches der Zieloberfläche, die vorher unter dem Blickfeld einer beschädigten Teillinse lag, auf eine neue Stelle beseitigt werden kann, an der dieser Bereich dem Blickfeld einer betriebsfähigen Teillinse ausgesetzt ist, daß Bezugsmarkensignalgeneratoreinrichtungen (39) zur Erzeugung von Bezugsmarkensignalen vorgesehen sind, die zur Verwendung bei dem Aneinanderheften der Begrenzungen des Blickfeldes benachbarter Teillinsen auf der Zieloberfläche und zur Neuausrichtung der Zieloberfläche nach dem Vertauschen zwischen dem gleichen Elektronenstrahlkanal oder verschiedenen Elektronenstrahlkanälen bestimmt sind, daß Abbildungsspeichereinrichtungen (41) zur Abbildung der Lage von Bereichen auf der Zieloberfläche, die dem Blickfeld einer beschädigten Teillinse ausgesetzt sind, und zum Speichern der Lage des einer beschädigten Teillinse ausgesetzten Bereiches der Zieloberfläche für ein nachfolgendes Auslesen und zur Verwendung mit den Bezugsmarkensignalen vorgesehen sind, um die Betriebsweise des Elektronenstrahls nach der Vertauschung der Zieloberfläche auf eine neue Lage zu steuern, in der die einer beschädigten Teillinse ausgesetzten Bereiche dem Blickfeld einer betriebsfähigen Teillinse ausgesetzt sind.

4. Vorrichtung nach Anspruch 3, dadurch gekennzeichnet, daß jeder Elektronenstrahlkanal weiterhin eine Elektronenstrahlerzeugungssystem-Leistungsversorgung (31), die mit dem Elektronenstrahlerzeugungssystem (13, 14A, 14B, 15A, 15B) verbunden ist, Elektronenstrahlunterdrückungselektroden (17), die von einer Elektronenstrahlunterdrückungssteuereinrichtung (32) gespeist werden, um den Elektronenstrahl vor seinem Hindurchlaufen durch den Kanal zu unterdrücken, ein optisches Elektronenstrahl-Fleckgrößenauswahlsystem (19) unter der Steuerung einer Elektronenstrahl-Fleckgrößen-Auswahlsteuereinrichtung (33) zur Steuerung der Querschnittsabmessungen des Elektronenstrahls, der zur Durchführung der Elektronenstrahllithographie verwendet wird, eine Elektronenstrahl-Schrittablenkbaugruppe (32), die von einer Elektronenstrahl-Schrittsteuereinrichtung (34) gesteuert wird, einen von einer Stigmations-Steuereinrichtung (34) gesteuerten Stigmator zur Steuerung des Elektronenstrahlastigmatismus und eine Grobablenksteuerung (36), die mit der Grobablenkeinrichtung (11) verbunden ist und deren Betrieb steuert, eine Teillinsenmatrix-Fokussierungssteuereinrichtung (36), die mit der Teillinsenmatrixbaugruppe (23) verbunden ist und deren Ansteuerung steuert, eine Feinablenksteuereinrichtung (38), die mit der Feinablenkbaugruppe (34) verbunden ist und deren Ansteuerung steuert, um die Feinablenkung des Elektronenstrahls nach dem Durchlaufen durch eine ausgewählte der Matrixteillinsen zu steuern, eine Feinablenk-Korrektursteuerung (37) und einen Stationscomputer (29) und ein getrenntes Kanalsteuergerät (30) einschließt, das auf die Bezugsmarkensignale anspricht, um die Betriebsweise der Elektronenstrahlkanäle gemeinsam in Verbindung mit den Zielpositions-Steuereinrichtungen zu steuern.

5. Vorrichtung nach Anspruch 4 unter Rückbeziehung auf Anspruch 3, dadurch gekennzeichnet, daß die Zielpositions-Steuereinrichtung (28) so ausgebildet ist, daß sie indirekt unter der Steuerung der Abbildungsspeichereinrichtungen (41) über den Stationscomputer (29) und das getrennte Kanalsteuergerät (30) steht.

6. Vorrichtung nach Anspruch 4 oder 5, dadurch gekennzeichnet, daß sie Bezugsmarkensignalverarbeitungsschaltungseinrichtungen (39) zur Formung und Verstärkung der Bezugsmarkensignale einschließt, und daß der Stationscomputer (29) und die einzelnen Kanalsteuergeräte (30) auf die Bezugsmarkensignale ansprechen, während sie den Betrieb der Elektronenstrahlkanäle steuern.

7. Vorrichtung nach einem der vorhergehenden Ansprüche, dadurch gekennzeichnet, daß sie Einrichtungen (Fig. 6) zur mechanischen Bewegung der Mittelachsenposition zumindestens des außen angeordneten Elektronenstrahlkanals oder der Kanäle bezüglich einander einschließt, um eine Anpassung an Zieloberflächen mit unterschiedlich bemessenen Oberflächenbereichen innerhalb des Gehäuses (12) zu erzielen.

8. Vorrichtung nach Anspruch 4 oder einem der Ansprüche 5—7 unter Rückbeziehung hierauf, dadurch gekennzeichnet, daß sie Spaltenpositions-Ansteuereinrichtungen einschließt, die auf den Stationscomputer (29) ansprechen, um automatisch die Mittelachse der Elektronenstrahlkanäle mechanisch auf eine gewünschte Position bezüglich der Zieloberfläche in einer vorpro-gram-mierten Weise zu bewegen.

9. Vorrichtung nach einem der vorhergehenden Ansprüche, dadurch gekennzeichnet, daß sie ein Musterausrichtgitter einschließt, daß auf oder in der Nähe der Zieloberfläche ausgebildet ist, um die Begrenzungen des Blickfeldes der jeweiligen Teillinsen innerhalb jeder Teillinsenmatrixbaugruppe (23) sowie die Begrenzungen des Blick-feldes jeder Teillinsenmatrixbaugruppe zu identi-fizieren.

10. Vorrichtung nach einem der vorhergehenden Ansprüche, dadurch gekennzeichnet, daß sie eine Zieloberfläche einschließt, die die Oberfläche einer ausgedehnten Halbleiterscheibe ist, auf der eine Vielzahl von integrierten Halbleiterschaltungsplättchen auszubilden ist.

11. Vorrichtung, dadurch gekennzeichnet, daß sie eine Vielzahl von Mehrkanal-Elektronenstrahlmatrix-Lithographiestationen, die jeweils aus einer Vorrichtung nach einem der vorhergehenden Ansprüche bestehen, und einen System-Hauptcomputer (44) zur Steuerung der Betriebsweise der Stationscomputer (29) umfaßt.

12. Verfahren zum Betrieb einer Mehr-kanal - Elektronenstrahlmatrix - Lithographievor-richtung nach einem der vorhergehenden Ansprüche mit einer Anzahl von Elektronenstrahlkanälen vom Matrixoptik-Typ, die in einem gemeinsamen Vakuumgehäuse (12) angeordnet sind, wobei jeder Kanal ein Elektronenstrahlerzeugungssystem (13, 14A, 14B, 15A, 15B) zur Erzeugung eines Elektronenstrahls, eine Teil-linsenmatrixbaugruppe (23), eine Matrix-Fein-ablenkbaugruppe (24) und eine Grobablenkbau-gruppe (11) umfaßt, die zwischen dem Elektronenstrahlzeugungssystem und der Teillinsenmatrixbaugruppe eingefügt ist, um selektiv den Elektronenstrahl auf eine gewünschte Matrix-teillinse der Teillinsenmatrixbaugruppe und die zugehörige Feinablenkeinrichtung zu lenken, die den Elektronenstrahl auf einen gewünschten Punkt auf einer Zieloberfläche lenkt, wobei das Verfahren den gleichzeitigen Parallelbetrieb aller Elektronenstrahlkanäle in Abhängigkeit von gemeinsamen mustergesteuerten Ablenksignalen umfaßt, die gemeinsam den jeweiligen Grob- und Feinablenkbaugruppen (11, 24) jedes Elektronenstrahlkanals zugeführt werden, um hierdurch gleichzeitig auf verschiedenen vorgegebenen Bereichen der Zieloberfläche zu schreiben.

13. Verfahren nach Anspruch 12, dadurch gekennzeichnet, daß die Zieloberfläche die Oberfläche einer ausgedehnten Halbleiterscheibe ist, auf der eine Vielzahl von integrierten Halbleiterschaltungsplättchen auszubilden ist, und daß der Oberflächenbereich jedes Halbleiterplättchens im wesentlichen gleich dem Blickfeld eines der Elektronenstrahlkanäle oder eines ganzzahligen Mehrfachen hiervon ist.

14. Verfahren nach Anspruch 12 oder 13, dadurch gekennzeichnet, daß die Zieloberfläche selektiv in einer x—y-Ebene bewegt wird, die im wesentlichen senkrecht zu den Elektronenstrahlkanälen steht.

15. Verfahren nach einem der Ansprüche 12—14, dadurch gekennzeichnet, daß ein oder mehrere der Anzahl von Elektronenstrahlkanälen eine Teillinsenmatrixbaugruppe aufweisen, von der ein oder mehrere Teillinsen beschädigt sein können, daß das Verfahren weiterhin die Ableitung von Bezugsmarkensignalen von einem auf oder in der Nähe der Zieloberfläche ausgebildeten Musterausrichtgitter zur Identifikation der Begrenzungen des Blickfeldes einer jeweiligen Matrix von Mikro-Teillinsen auf der Zieloberfläche zur Verwendung beim Anheften der kombinierten Blickfelder der Teillinsenmatrixbaugruppen aneinander in einer ausreichenden Weise zur Überdeckung eines gewünschten Bereiches der zu bestrahlenden Zieloberfläche, das Bestrahlen des gewünschten Bereiches der Oberfläche mit dem Elektronenstrahl, die Abbildung der Lage irgendeines Fleckes auf dem bestrahlten Bereich der Zieloberfläche, der dem Blickfeld einer beschädigten Teillinse in einer Teillinsenmatrixbaugruppe ausgesetzt war, in einem Computerspeicher, während der Betrieb der beschädigten Teillinse unterdrückt wird, das Vertauschen der physikalischen Position des bestrahlten Zieloberflächenbereiches auf eine neue physikalische Position, die dem Blickfeld eines anderen Satzes von Matrixteillinsen ausgesetzt ist, deren kombinierte Blickfelder erneut den gewünschten Bereich der zu bestrahlenden Zieloberfläche überdeckt, das Ableiten von Rücklaufsteuersignalen aus dem Computerspeicher zur Steuerung des Betriebes von zumindestens der Grobablenk- und der Feinablenkbaugruppe des Elektronenstrahlkanals zum Rückführen des Elektronenstrahls zurück auf den durch die beschädigte Teillinse hervorgerufenen unbestrahlten Fleck, und die Rückführung des Elektronenstrahls über einen derartigen Fleck entsprechend den Hauptmusterspezifikationen für die Flecklage auf der Zieloberfläche einschließt, wodurch ein vergrösserter Ertrag des Elektronenstrahlmatrix-Lithographiesystems (EBAL) erzielt wird.

16. Verfahren nach Anspruch 15, dadurch gekennzeichnet, daß es die Verwendung der von dem Musterausrichtgitter abgeleiteten Bezugsmarkensignale zur Steuerung der Neuausrichtung der Zieloberfläche nach der Entfernung, Teilverarbeitung und dem erneuten Einsetzen der Zieloberfläche in die gleiche oder eine andere Elektronenstrahlmatrix-Lithographiestation durch automatisches Steuern der Positionierung der Zieloberfläche mit den Bezugsmarkensignalen relativ zu den Matrixteillinsen und der Feinablenkbaugruppe umfaßt, um eine Drehung, Ausdehnung, Linearverschiebung und andere ähnliche Zieleinsetzfehler sowie eine Zielverwerfung oder Abmessungsänderungen aufgrund von dazwischenliegenden Verarbeitungen des Ziels, aufgrund einer thermischen Ausdehnung, von Ausdehnungsgradienten, unterschiedlichen Ausdehnungen innerhalb der Teillinsenmatrixbaugruppe und des Ziels und anderer ähnlicher Fehler bei der Positionierung der Zieloberfläche nach ihrer Entfernung, Teilverarbeitung und dem erneuten Einsetzen in die gleiche oder eine andere EBAL-Station zu korrigieren.

17. Verfahren nach einem der Ansprüche 12—16, dadurch gekennzeichnet, daß es weiterhin die Herstellung eines Teillinsen-Anheft-Eichgitters, auf dem ein gitterartiges Netzwerk von Bezugsmarkenelementen ausgebildet ist, die Verwendung des Eichgitters zur Ableitung von Bezugsmarkensignalen, die die Begrenzungen des Blickfeldes der einzelnen Elemente der Teillinsenmatrixbaugruppe jedes Elektronenstrahlkanals anzeigen, und die Verwendung der Bezugsmarkensignale zur Steuerung der jeweiligen Elektronenstrahlkanäle derart umfaßt, daß die einzelnen Blickfelder der Elemente in der Teillinsenmatrixbaugruppe jedes Elektronenstrahlkanals aneinander angepaßt oder angeheftet werden und daß die kombinierten Blickfelder der Teillinsenmtrixbaugruppen aneinander angepaßt oder angeheftet werden, um einen gewünschten Bereich der mit den Elektronenstrahlen zu bestrahlenden Zieloberfläche zu überdecken, der eine größere Oberfläche aufweist, als der Bereich, der durch das Blickfeld eines einzelnen Matrix-Teillinsenelementes überdeckt ist, wobei auf dem Teillinsenanheft-Eichgitter Bezugsmarkenelemente an Positionen ausgebildet sind, die zumindestens einer Anzahl von Punkten entlang der Begrenzungen des Blickfeldes jedes Teillinsenelementes der Teillinsenmatrixbaugruppe jedes Elektronenstrahlkanals entsprechen.

18. Verfahren nach Anspruch 17, dadurch gekennzeichnet, daß die Zieloberfläche eine Halbleiterscheibe ist, auf der eine Anzahl von integrierten Schaltungsplättchen unter Verwendung der ELektronenstrahllithographie auszubilden sind, und daß das Verfahren weiterhin die Ausbildung von Bezugsmarkenelementen an zumindestens einer Anzahl von Punkten auf den Begrenzungen jedes Halbleiterplättchens zur Ausbildung von Halbleiterplättchen-Ausrichtgittern, die Messung der x—y-Koordinatenpositionen der Halbleiterplättchen-Ausrichtgitter-Bezugselemente für Abbildungszwecke und die Transformation der abgebildeten Ausrichtgitter-Koordinatenpositionen in entsprechende Positionen auf dem Teillinsen-Anheft-Eichgitter umfaßt, mit deren Hilfe Muster tatsächlich auf den Halbleiterplättchen mit den Elektronenstrahlkanälen vom Matrixoptik-Typ beschrieben werden, so daß Halbleiterplättchen-für-Halbleiterplättchen-Korrekturen von Halbleiterscheiben-Einsetzfehlern aufgrund einer Verschiebung oder Drehung und von Halbleiterschiebenabmessungsänderungen aufgrund von Ausdehnungen oder vierseitigen Verzerrungen durchgeführt werden können.

19. Verfahren nach Anspruch 17 oder 18, dadurch gekennzeichnet, daß eine erhöhte und größere Genauigkeit durch die Hinzufügung von zusätzlichen Bezugsmarken entlang der Begrenzungen der Blickfelder der Teillinsenmatrixbaugruppen auf dem Teillinsen-Anheft-Eichgitter erzielt werden kann, um mehr Messungen zu gewinnen, mit denen die Werte zusätzlicher Konstanten bestimmt werden, die bei der mathematischen Definition des Teillinsen-Anheft-Eichgitters verwendet werden.

20. Verfahren nach einem der Ansprüche 17—19, dadurch gekennzeichnet, daß es weiterhin did Korrektur von Höhenverschiebungsunterschieden aufgrund von Unterschieden zwischen der vertikalen Anordnung des Teillinsen-Anheft-Eichgitters und der Zieloberfläche entlang des Elektronenstrahlpfades in dem Elektronenstrahlkanal einschließt.

21. Verfahren nach einem der Ansprüche 12—20, dadurch gekennzeichnet, daß der Oberflächenbereich der Zieloberfläche im wesentlichen gleich irgendeinem ganzzahligen Vielfachen des Zieloberflächenbereiches ist, der von dem Elektronenstrahlkanal überdeckt wird, und daß das Verfahren die mechanische Bewegung der Zieloberfläche selektiv in einer vorprogrammierten Weise gegenüber den Mittelachsen der Anzahl von Elektronenstrahlkanälen umfaßt, so daß im wesentlichen der gesamte Oberflächenbereich der Zieloberfläche unter das kombinierte Blickfeld der Anzahl von Elektronenstrahlkanälen gebracht werden kann.

22. Verfahren nach einem der Ansprüche 12—21, dadurch gekennzeichnet, daß das Verfahren gleichzeitig in einer Anzahl von parallel betriebenen Elektronenstrahlmatrix-Lithographievorrichtungen ausgeführt wird, wobei jede EBAL-Vorrichtung eine Anzahl von Elektronenstrahlkanälen umfaßt und eine Hochspannungsleistungs- und Elektronenstrahlerzeugungssystem-Leistungsversorgung, eine musterpositionsabhängige dynamische Fokussierung, eine Stigmatisierung, eine Ablenkung, eine Strahlunterdrückung und eine Elektronenstrahlfleckgrößenauswahl aufweist, die gemeinsam durch einen Gesamtsystem-Hauptcomputer gesteuert werden, .während die Halbleiterplättchenausrichtung, die Dreh- und Translationsbewegungssteuerung für die Teillinsenanheftung, der Abbildungsspeicher für beschädigte Teillinsen und die Steuerung und Grobablenkung für den Abbildungsspeicher und die Steuerung für beschädigte Teillinsen und die Grobablenkung für den Korrekturspeicher und die Steuerung für beschädigte Teillinsen alle getrennt für jede EBAL-Vorrichtung von einem getrennten Stationscomputer gesteuert werden, entweder allein oder in Verbindung mit einem getrennten Kanalsteuergerät.

23. Verfahren nach einem der Ansprüche 12—22, dadurch gekennzeichnet, daß eine Anzahl von parallel betriebenen Elektronenstrahlmatrixlithographiestationen vorgesehen ist, wobei jede Elektronenstrahlmatrixlithographiestation eine Anzahl von Elektronenstrahlkanälen umfaßt, daß weiterhin ein Systemhauptcomputer zur gemeinsamen Steuerung bestimmter Bauteile aller der Elektronenstrahlkanäle vom Matrixoptik-Typ der Anzahl von Elektronenstrahlmatrixlithographiestationen und eine Anzahl von getrennten Stationscomputern vorgesehen ist, die jeweils einer einzelnen Elektronenstrahlmatrixlithographiestation und einem einzelnen Elektronenstrahlkanalsteuergerät zur Steuerung des Betriebes der übrigen Bauteile der jeweiligen Elektronenstrahlröhre allein oder in Verbindung miteinander zugeordnet sind.

24. Verfahren nach einem der Ansprüche 12—23, gekennzeichnet durch den Einschluß einer mechanischen Bewegung der Mittelachsenposition von zumindestens der außen angeordneten Elektronenstrahlkanäle relativ zueinander, um eine Anpassung an Zieloberflächen mit unterschiedlicher Oberfächengröße innerhalb des gemeinsamen Vakuumgehäuses zu erzielen.

## Revendications

1. Appareil de lithographie à réseaux de faisceaux d'électrons à canaux multiples comportant plusieurs canaux de faisceaux d'électrons fonctionnant en parallèle du type à réseau optique (11), chacun du type à facettes multiples comprenant un canon à électrons (13, 14A, 14B, 15A, 15B) pour produire un faisceau d'électrons, un ensemble de lentilles de réseau (23), un ensemble de déflecteurs précis respectifs (24) et un déflecteur grossier (11) pour diriger sélectivement le faisceau d'électrons vers une lentille de réseau voulue dans l'ensemble de lentilles de réseau et son déflecteur précis respectif qui dirige ensuite le faisceau d'électrons vers un point voulu sur une surface de cible, et une enveloppe sous vide (12), caractérisé en ce que l'enveloppe sous vide enferme tous les canaux de faisceau d'électrons, en ce que ledit appareil comporte en outre une platine mobile commune (25) destinée à supporter la surface de cible au-dessous des canaux de faisceaux d'électrons et à déplacer la surface de cible par rapport à tous les canaux de faisceaux d'électrons, et un dispositif de commande de position de cible (28) pour déplacer automatiquement ladite platine mobile commune (25) de façon pré-programmée de manière que pratiquement toute la surface de cible soit amenée au-dessous de la vue combinée des canaux de faisceaux d'électrons, la platine mobile commune (25) étant mobile sélectivement dans un plan x—y qui est pratiquement normal aux canaux de faisceaux d'électrons au moyen d'un mécanisme de translation x—y (26) commandé automatiquement par ledit dispositif de commande de position de cible (28), le mécanisme de translation étant accouplé mécaniquement avec la platine mobile.

2. Appareil selon la revendication 1, caractérisé par un accouplement flexible et étanche au vide (27) qui accouple mécaniquement le mécanisme de translation (26) avec la platine mobile commune (25).

3. Appareil selon la revendication 1 ou 2, caractérisé en ce qu'une ou plusieurs des lentilles et/ou des déflecteurs précis associés dans l'un des ensembles de lentilles de réseau (23) peut être défectueux, ledit dispositif de commande de position de cible (28) comprenant un dispositif qui permute selectivement la surface de cible sur laquelle un faisceau d'électrons est incident pendant des expositions successives de la surface aux faisceaux d'électrons de manière que l'effet d'une lentille défectueuse puisse être éliminé par transposition de la surface de la cible qui se trouvait précédemment au-dessous de champ de vision d'une lentille défectueuse jusqu'à une nouvelle position dans laquelle elle est soumise au champ de vision d'une lentille qui fonctionne, un dispositif (39) de production de signal de marquage de repérage étant prévu pour produire des signaux de marquage de repérage destiné à l'enchaînement de la limite du champ de vision de lentilles voisines sur la surface de cibles et pour positionner à nouveau la surface de cible après la permutation entre les mêmes ou des canaux de faisceaux d'électrons différents, le dispositif à mémoire de disposition (41) étant prévu pour disposer la position de régions de la surface de cible qui sont soumises au champ de vision d'une lentille défectueuse et mémorisant la position de la région soumise à une lentille défectueuse de la surface de cible pour une lecture ultérieure et une utilisation avec les signaux de marquage de repérage pour commander le fonctionnement d'un faisceau d'électrons après la permutation de la surface de cible jusqu'à une nouvelle position dans laquelle les régions soumises à des lentilles défectueuses sont soumises au champ de vision d'une lentille correcte.

4. Appareil selon la revendication 3, caractérisé en ce que chaque canal de faisceau d'électrons comporte en outre une alimentation de canons d'électrons (13, 14A, 14B, 15A, 15B), des électrodes de blocage de faisceaux d'électrons (17) alimentées par un circuit (32) de commande de blocage de faisceaux d'électrons pour bloquer le faisceau d'électrons avant son passage par le canal, un système optique (19) de sélection de dimensions de spot de faisceaux d'électrons commandé par le dispositif (33) de commande de sélection de dimensions de spot de faisceaux d'électrons pour commander les dimensions transversales du faisceaux d'électrons utilisés pour effectuer une lithographie par faisceau d'électrons, un ensemble (22) déflecteur de progression pas à pas de faisceaux d'électrons commandé par un dispositif (34) de commande de progression pas à pas de faisceaux d'électrons, un dispositif de stigmatisme à la commande d'un dispositif de commande de stigmatisme (34) qui commande l'astigmatisme du faisceau d'électrons et une commande de déviation grossière (36) connectée au déflecteur grossier (11) pour en commander le fonctionnement, un dispositif (36) de commande de focalisation de lentilles de réseau connecté à l'ensemble de lentilles de réseau (23) et en commandant l'excitation, un dispositif (38) de commande de déflecteur précis connecté à l'ensemble de déflecteur précis (24) et en commandant l'excitation pour commander la déviation précise du faisceau d'électrons après son passage par l'une sélectionnée des lentilles de réseau, une commande de correction de déviation précise (37), et un calculateur de poste (29) ainsi qu'un moniteur de canal individuel (30) réagissant aux signaux de marquage de repérage en commandant le fonctionnement des canaux de faisceaux d'électrons en commun et conjointement avec le dispositif de commande de position de cible.

5. Appareil selon la revendication 4, dépendant de la revendication 4, caractérisé en ce que le dispositif (28) de commande de position de cible est agencé pour être indirectement sous le contrôle dudit dispositif de mémoire de disposition (41) par l'intermédiaire du calculateur de poste (29) et du moniteur de canal individuel (30).

6. Appareil selon la revendication 4 ou 5, caractérisé par un circuit (39) de traitement de signaux de repérage pour mettre en forme et amplifier les signaux de marquage de repérage, le calculateur de poste (29) et le moniteur de canal individuel (30) réagissant aux signaux de marquage de repérage tout en commandant le fonctionnement des canaux de faisceaux d'électrons.

7. Appareil selon l'une quelconque des revendications précédentes, caractérisé en ce qu'il comporte un dispositif (Fig. 6) destiné à déplacer mécaniquement la position d'axe central d'au moins le ou les canaux de faisceaux d'électrons disposés à l'extérieur, l'un par rapport à l'autre, de manière à s'adapter à des surfaces de cibles avec des régions de surface de dimensions différentes dans l'enceinte (12).

8. Appareil selon la revendication 4, ou l'une quelconque des revendications 5 à 7, qui en dépend, caractérisé en ce qu'il comporte un dispositif d'entraînement de positionnement de colonne qui réagit au calculateur de poste (29) en déplaçant mécaniquement et automatiquement l'axe central des canaux de faisceaux d'électrons jusqu'à une position voulue par rapport à la surface de cible, de manière préprogrammée.

9. Appareil selon l'une quelconque des revendications précédentes, caractérisé en ce qu'il comporte une grille d'alignement de configuration formée sur ou près de la surface de cible pour identifier les limites du champ de vision des lentilles respectives dans chaque ensemble de lentilles de réseaux (23) ainsi que les limites du champ de vision de chaque ensemble de lentilles de réseau.

10. Appareil selon l'une quelconque des revendications précédentes, caractérisé en ce qu'il comporte une surface de cible qui est la surface d'une plaquette semi-conductrice agrandie sur laquelle plusieurs pastilles de circuits intégrés à semi-conducteurs doivent être formées.

11. Appareil caractérisé en ce qu'il comporte plusieurs postes de lithographie à réseaux de faisceaux d'électrons à canaux multiples consistant chacun en un appareil tel que revendiqué dans l'une quelconque des revendications précédentes, et un calculateur d'exploitation de système (44) pour commander le fonctionnement des calculateurs de poste (29).

12. Procédé de fonctionnement d'un appareil de lithographie à réseau de faisceaux d'électrons à canaux multiples tels que revendiqués dans l'une quelconque des revendications précédentes, comprenant plusieurs canaux de faisceaux d'électrons du type à réseaux optiques logé dans une enveloppe commune sous vide (12), chacun desdits canaux comprenant un canon à électrons (13, 14A, 14B, 15A, 15B) pour produire un faisceau d'électrons, un ensemble de lentilles de réseaux (23) un ensemble de déflecteurs précis de réseaux (24) et un ensemble de déflecteur grossier (11) intercalé entre le canon à électrons et l'ensemble de lentilles de réseau pour diriger sélectivement le faisceaux d'électrons vers une lentille de réseaux voulue dans l'ensemble de lentilles de réseau, et son déflecteur précis respectif qui dirige le faisceau d'électrons vers un point voulu sur une surface de cible, ledit procédé consistant à faire fonctionner simultanément et en parallèle tous lesdits canaux de faisceaux d'électrons en réponse à des signaux de déviation commandés par une configuration commune appliquée en commun aux ensembles respectifs de déflecteurs grossiers et précis (11, 24) de chaque canal de faisceau d'électrons de manière à écrire simultanément sur des régions prédéterminées et différentes de la surface de cible.

13. Procédé selon la revendication 12, caractérisé en ce que la surface de cible est la surface d'une plaquette semi-conductrice agrandie sur laquelle plusieurs pastilles de circuits intégrés à semi-conducteurs doivent être formées et la région de surface de chaque pastille étant pratiquement égale au champ de vision de l'un des canaux de faisceaux d'électrons ou d'un certain multiple entier de ce champ.

14. Procédé selon la revendication 12 ou 13, caractérisé en ce que la surface de cible est déplacée sélectivement dans un plan x—y qui est pratiquement perpendiculaire aux canaux de faisceaux d'électrons.

15. Procédé selon l'une quelconque des revendications 12 à 14, caractérisé en ce qu'un ou plusieurs des canaux de faisceaux d'électrons comportent un ensemble de lentilles de réseau dont une ou plusieurs peut être défectueuse, le procédé consistant en outre à produire des signaux de marquage de repérage à partir d'une grille d'alignement de configuration formée sur ou au voisinage de la surface de cible pour identifier les limites du champ de vision d'un réseau respectif de micro-lentilles sur la surface de cible pour l'utilisation dans un marquage en pointillés des champs combinés de vision des ensembles de lentilles de réseau suffisantes pour couvrir une région voulue de la surface de cible à exposer, à exposer la région voulue de la surface au faisceau d'électrons, à disposer dans une mémoire de calculateur la position d'un spot sur la région de surface de cible exposée qui a été soumise au champ de vision d'une lentille défectueuse dans un ensemble de lentilles de réseau tout en bloquant le fonctionnement de la lentille défectueuse, à permuter la position physique de la région de surface de cible exposée jusqu'à une nouvelle position physique soumise au champ de vision d'un ensemble différent de lentilles de réseau dont les champs de vision combinés couvrent à nouveau la région voulue de la surface de cible à exposer, à produire à partir de la mémoire de calculateur des signaux de commande de retour pour commander le fonctionnement d'au moins l'ensemble de déflecteur grossier et l'ensemble de déflecteur précis du canal de faisceau d'électrons pour orienter à nouveau le faisceau d'électrons sur le spot précédemment non exposé en raison de la lentille défectueuse et à balayer à nouveau le faisceau d'électrons sur ce spot en fonction de spécifications de configuration principale pour la position de spot sur la surface de cible de manière à obtenir un rendement plus élevé du système EBAL.

16. Procédé selon la revendication 15, caractérisé en ce qu'il consiste à utiliser les signaux de marquage de repérage produits à partir de la grille de positionnement de configuration pour commander un nouveau positionnement de la surface de cible après l'enlèvement, le traitement partiel et la nouvelle insertion de la surface de cible dans le même poste ou un poste différent de lithographie à réseaux d'électrons en commandant automatiquement le positionnement de la surface de cible avec les signaux de marquage de repérage par rapport aux lentilles de réseau et à l'ensemble de déflecteur précis pour corriger le déplacement par rotation, expansion, déplacement linéaire et autres erreurs similaires d'insertion de cible ainsi que de gauchissement de cible ou de changements dimensionnels résultant d'un traitement intermédiaire de la cible, de dilatation thermique, de gradients d'expansion, de dilatation différentielle entre l'ensemble de lentilles de réseau et de la cible et autres erreurs similaires dans le positionnement de la surface de cible après son enlèvement, son traitement partiel et sa nouvelle insertion dans le même poste EBAL ou un poste différent.

17. Procédé selon l'une quelconque des revendications 12 à 16, caractérisé en ce qu'il consiste en outre à fabriquer une grille d'étalonnage d'enchaînement de lentilles sur laquelle est formée un réseau en forme de grille d'éléments de marquage de repérage, à utiliser ladite grille d'étalonnage pour produire des signaux de marquage de repérage indiquant les limites du champ de vision des éléments individuels de l'ensemble de lentilles de réseau de chaque canal de faisceaux d'électrons et à utiliser lesdits signaux de marquage de repérage pour commander les canaux respectifs de faisceaux d'électrons de manière à enchaîner ensemble les champs de vision individuels des éléments dans l'ensemble de lentilles de réseau de chaque canal de faisceaux d'électrons, et à enchaîner les champs combinés de vision des ensembles de réseau pour couvrir une région voulue d'une surface de cible à exposer aux faisceaux d'électrons et qui est supérieure dans la région superficielle à la région couverte par le champ de vision d'un élément individuel de lentilles de réseau, la grille d'étalonnage d'enchaînement des lentilles étant formée avec des éléments de marquage de repérage à des positions qui correspondent au moins à plusieurs points le long de la limite du champ de vision de chaque élément de lentilles de l'ensemble de lentilles de réseau de chaque canal de faisceau d'électrons.

18. Procédé selon la revendication 17, caractérisé en ce que la surface de cible est une plaquette semi-conductrice sur laquelle plusieurs pastilles de circuits intégrés peuvent être formées en utilisant la lithographie par faisceaux d'électrons, et comportant en outre des éléments de marquage de repérage sur au moins plusieurs points de limites de chaque pastille de manière à former des grilles d'alignement de pastilles, à mesurer les positions de coordonnées x—y des éléments de repérage de grilles d'alignement de pastilles pour des buts de disposition et à transformer les positions de coordonnées disposées dans la grille d'alignement de pastilles en des positions correspondantes sur la grille d'éalonnage d'enchaînement de lentilles au moyen desquelles des configurations sont réellement écrites sur les pastilles avec les canaux de faisceaux d'électrons du réseau optique de manière que des corrections puissent être faites pastille par pastille pour des erreurs d'insertion de plaquettes semi-conductrices résultant d'une translation ou d'une rotation et pour des variations de dimensions résultant de dilatations ou de distorsions quadrilataires.

19. Procédé selon la revendication 17 ou 18, caractérisé en ce qu'une précision accrue et plus grande peut être obtenue par l'addition de plus de marquages de repérage le long des limites des champs de vision des ensembles de lentilles de réseau sur la grille d'étalonnage d'enchaînement de lentilles afin de produire plus de mesure avec lesquelles sont déterminées les valeurs de constantes additionnelles utilisées pour la définition mathématique de la grille d'étalonnage d'enchaînement de lentilles.

20. Procédé selon l'une quelconque des revendications 17 à 19, caractérisé en ce qu'il consiste en outre à corriger des ·différences de déplacement en hauteur résultant d'une différence entre le positionnement vertical de la grille d'étalonnage d'enchaînement de lentilles et la surface de cible le long du trajet de faisceaux d'électrons dans le canal de faisceaux d'électrons.

21. Procédé selon l'une quelconque des revendications 12 à 20, caractérisé en ce que la région de surface de la surface de cible est pratiquement égale à un multiple entier de la région de surface de cible vue par le canal de faisceau d'électrons, le procédé consistant à déplacer mécaniquement la surface de cible sélectivement de façon préprogrammée par rapport aux axes centraux des canaux de faisceau d'electrons de manière que pratiquement toute la région de surface de la surface de cible puisse être amenée sous la vue combinée des canaux de faisceaux d'électrons.

22. Procédé selon l'une quelconque des revendications 12 à 21, caractérisé en ce qu'il est conduit simultanément dans plusieurs appareils de lithographie à réseaux de faisceaux d'électrons fonctionnant en parallèle, chaque appareil EBAL comportant plusieurs canaux de faisceaux d'électrons et ayant une alimentation à haute tension et une alimentation de canaux d'électrons, une focalisation dynamique dépendant d'une position de configuration, un stigmatisme, une déviation, un blocage et une sélection de grosseur de spot de faisceaux d'électrons commandés en commun par un calculateur d'exploitation de systèmes d'ensemble et d'alignement de plastilles, une commande de mouvement de rotation et de translation d'enchaînement de lentilles, une mémoire de disposition de lentilles défectueuses et une commande et une déviation grossières pour une mémoire de disposition de lentilles défectueuses et une commande et une déviation grossières pour une mémoire de correction de lentilles défectueuses et une commande, tous commandés individuellement pour chaque appareil EBAL au moyen d'un calculateur individuel de poste, seul ou conjointement avec un moniteur de canal individuel.

23. Procédé selon l'une quelconque des revendications 12 à 22, caractérisé en ce qu'il utilise plusieurs postes de lithographie à réseau de faisceaux d'électrons fonctionnant en paralèlle, chaque poste de lithographie à réseaux de faisceaux d'électrons comportant plusieurs canaux de faisceaux d'électrons et comportant en outre un calculateur d'exploitation de système pour commander le fonctionnement de certains composants ·de tous les canaux à faisceaux d'électrons de type à réseaux optiques parmi les plusieurs postes de lithographie à réseaux de faisceaux d'électrons en commun et plusieurs calculateurs de postes individuels associés respectivement chacun avec un poste de lithographie à réseaux de faisceaux d'électrons individuels et un moniteur individuel de canaux de faisceaux pour commander le fonctionnement des autres composants de son tube à faisceaux d'électrons respectifs seuls ou conjointement les uns avec les autres.

24. Procédé selon l'une quelconque des revendications 12 à 23, caractérisé en ce qu'il consiste en outre à placer mécaniquement la position d'axe central d'au moins les canaux de faisceaux d'électrons disposés à l'extérieur les uns par rapport aux autres afin de correspondre à des surfaces de cibles de régions superficielles de dimensions différentes dans l'enveloppe commune sous vide.

0 066 404

_fig.1_

_fig.6_

CHANNEL
POSITIONING
DRIVE
MOTOR

CHANNEL
DRIVE MOTOR
CONTROLLER
56

1

_Fig.2_

Fig.3A

Fig. 3B

0 066 404

*Fig. 4*

LEGEND
T THERMAL
FE FIELD EMITTER
C CHANNEL

0 066 404

Fig.5A     Fig.5B     Fig.5.C

LEGEND

———— CHANNEL FIELDS

— — — — CHIPS

□   CHIP FIDUCIAL MARKS